# FASCICULE DE BREVET EUROPEEN

(11) **EP 2 361 442 B1**
(45) Date de publication et mention de la délivrance du brevet: **30.01.2013**
(21) Numéro de dépôt: 09755929.8
(22) Date de dépôt: 20.10.2009
(51) Int. Cl.: H01L 37/04, F25B 21/00, F25B 29/00

(54) **GENERATEUR THERMIQUE MAGNETOCALORIQUE**
MAGNETOKALORISCHER THERMISCHER GENERATOR
MAGNETOCALORIC THERMAL GENERATOR

(30) Priorité: 24.10.2008 FR 0805901
(43) Date de publication de la demande: 31.08.2011
(73) Titulaire: Cooltech Applications S.A.S., 67810 Holtzheim (FR)
(72) Inventeur: HEITZLER, Jean-Claude, F-68180 Horbourg-Wihr (FR); MULLER, Christian, F-67000 Strasbourg (FR)
(74) Mandataire: Koelbel, Caroline
(86) Numéro de dépôt international: PCT/FR2009/001223
(87) Numéro de publication internationale: WO 2010/046559

(56) Documents cités:
- WO-A-2004/059221
- FR-A- 2 904 098
- FR-A- 2 914 051

## Description

### Domaine technique :

La présente invention concerne un générateur thermique comportant au moins un module thermique comprenant au moins deux éléments magnétocaloriques adjacents agencés pour être traversés par un fluide caloporteur, une chambre commune de distribution associée à un moyen de circulation du fluide caloporteur reliant fluidiquement entre eux lesdits éléments magnétocaloriques adjacents et deux chambres d'extrémité également associées à un moyen de circulation et reliées fluidiquement respectivement avec l'élément magnétocalorique situé aux extrémités dudit module thermique, dites extrémité chaude et extrémité froide, et un arrangement magnétique destiné à soumettre chaque élément magnétocalorique à un champ magnétique variable, créant alternativement, dans chaque élément magnétocalorique un cycle de chauffage et un cycle de refroidissement, la circulation du fluide caloporteur à travers lesdits éléments magnétocaloriques étant réalisée par les moyens de circulation en synchronisation avec la variation du champ magnétique.

### Technique antérieure :

La technologie du froid magnétique est connue depuis plus d'une vingtaine d'années et on sait les avantages qu'elle apporte en termes d'écologie et de développement durable. On connaît également ses limites quant à sa puissance thermique utile et à son rendement. Dès lors, les recherches menées dans ce domaine tendent toutes à améliorer les performances d'un tel générateur, en jouant sur les différents paramètres, tels que la puissance d'aimantation, les performances de l'élément magnétocalorique, la surface d'échange entre le fluide caloporteur et les éléments magnétocaloriques, les performances des échangeurs de chaleur, etc.

Le choix des matériaux magnétocaloriques est déterminant et influence directement les performances d'un générateur thermique magnétocalorique. Pour augmenter ces performances, une solution consiste à associer plusieurs matériaux magnétocaloriques présentant des températures de Curie différentes en vue d'augmenter le gradient de température entre les extrémités de cet assemblage.

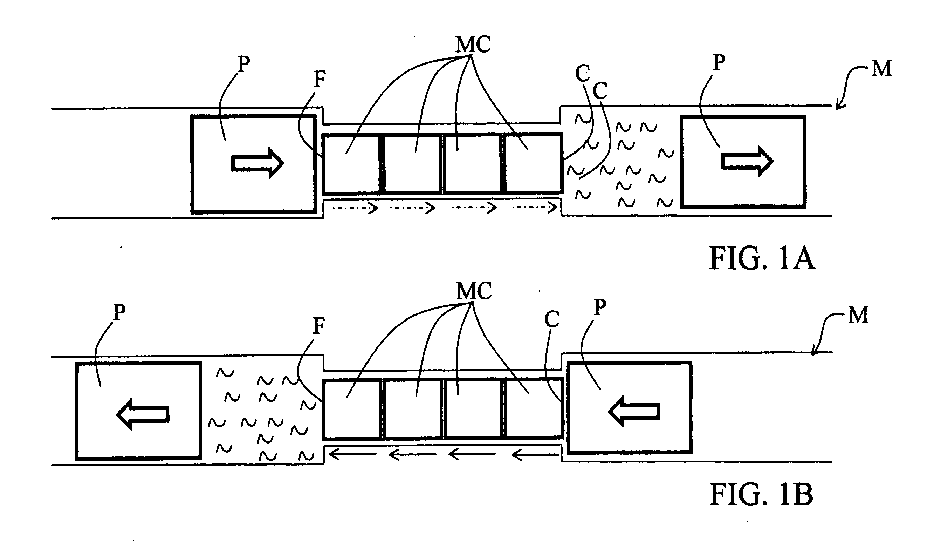

On connaît ainsi des générateurs thermiques comportant au moins un module thermique M tel que celui représenté sur les figures 1A et 1B et comportant des matériaux magnétocaloriques MC disposés côte-à-côte et alignés, et des moyens de circulation du fluide caloporteur, tels que des pistons P, destinés à entraîner le fluide caloporteur selon un mouvement de va et vient à travers l'ensemble des matériaux magnétocaloriques MC, de part et d'autre de ces derniers, entre le côté froide F et le côté chaud C de l'assemblage de matériaux magnétocaloriques MC, et en synchronisation avec la variation d'un champ magnétique. Comme cela est représenté sur les figures 1A et 1B, ces pistons P sont disposés de part et d'autre de l'assemblage de matériaux magnétocaloriques MC et se déplacent alternativement dans un sens puis dans l'autre, les figures 1A et 1B représentant les pistons dans leurs deux positions extrêmes.

Il ressort des figures 1A et 1B que le fluide se déplace soit dans un sens, en direction de l'extrémité chaude C (le sens de déplacement du fluide caloporteur est représenté par les flèches en pointillés, cf. figure 1A) lorsque les matériaux magnétocaloriques subissent un cycle d'échauffement, soit dans l'autre sens, en direction de l'extrémité froide F (le sens de déplacement du fluide caloporteur est représenté par les flèches en trait plein, cf. figure 1B) lorsque les matériaux magnétocaloriques subissent un cycle de refroidissement.

Ce module thermique M présente un inconvénient dû au fait que pour atteindre un gradient de température, il est nécessaire de faire circuler un fluide caloporteur à travers l'ensemble des matériaux. L'utilisation de plusieurs éléments magnétocaloriques MC entraîne une augmentation de la longueur de matériau à traverser par ledit fluide caloporteur. Ainsi, pour ne pas diminuer le nombre de cycles (un cycle étant défini par un échauffement et un refroidissement de l'élément magnétocalorique), il est nécessaire d'augmenter la vitesse du fluide caloporteur. Or, l'augmentation de vitesse a pour effets une augmentation de la pression, ce qui aggrave les pertes de charge et diminue l'efficacité de l'échange thermique entre le fluide caloporteur et les éléments magnétocaloriques, ce qui entraîne une réduction du rendement thermique du générateur magnétocalorique.

On sait également que pour augmenter la puissance thermique d'un générateur magnétocalorique, une possibilité consiste à augmenter le nombre de cycles. Or, cela a pour effet une augmentation de la vitesse, et entraîne les inconvénients précités.

Un générateur comportant un module thermique M tel qu'illustré dans les figures 1A et 1B nécessite une durée de fonctionnement préalable non négligeable pour atteindre un gradient de température exploitable entre les deux extrémités du fait de la multiplicité des matériaux utilisés.

### Exposé de l'invention:

La présente invention vise à pallier ces inconvénients en proposant un générateur thermique magnétocalorique facile à mettre en oeuvre et dont le rendement thermique est amélioré par rapport aux générateurs connus, ce avec une même quantité ou longueur de matériau magnétocalorique.

Dans ce but, l'invention concerne un générateur thermique du genre indiqué en préambule, caractérisé en ce que ledit moyen de circulation associé à ladite chambre commune de distribution déplace le fluide caloporteur simultanément à travers les deux éléments magnétocaloriques adjacents, dans des sens de circulation différents.

De préférence, l'arrangement magnétique peut assujettir constamment lesdits éléments magnétocaloriques adjacents dans deux cycles différents et ledit moyen de circulation associé à ladite chambre commune peut déplacer le fluide caloporteur de manière simultanée, à travers l'élément magnétocalorique subissant un cycle de chauffage, en direction de l'extrémité chaude et, à travers l'élément magnétocalorique subissant un cycle de refroidissement, en direction de l'extrémité froide dudit module thermique.

Ledit module thermique peut en outre comporter au moins trois éléments magnétocaloriques, ledit moyen de circulation associé à ladite chambre commune peut déplacer le fluide caloporteur alternativement en direction des deux éléments magnétocaloriques adjacents puis dans la direction opposée, en sortie desdits modules thermiques adjacents, et inversement, deux moyens de circulation de deux chambres communes consécutives peuvent déplacer constamment le fluide caloporteur dans deux directions opposées, et les moyens de circulation associés auxdites chambres d'extrémité peuvent déplacer le fluide caloporteur dans la direction opposée à celle de la chambre commune qui leur est adjacente.

De préférence, le générateur thermique peut comporter un nombre pair d'éléments magnétocaloriques. De cette manière, à tout moment, chaque module thermique comporte autant d'éléments magnétocaloriques en cycle d'échauffement que d'éléments magnétocaloriques en cycle de refroidissement.

Pour augmenter la plage de température de fonctionnement du générateur (par exemple entre -25°C et +65°C), lesdits éléments magnétocaloriques peuvent comporter chacun une température de Curie différente et être disposés de manière adjacente selon leur température de Curie croissante en direction de l'extrémité chaude dudit module thermique.

Dans cette configuration, lesdits éléments magnétocaloriques peuvent également comporter chacun plusieurs matériaux magnétocaloriques agencés selon une température de Curie croissante en direction de l'extrémité chaude dudit module thermique.

De manière caractéristique, le volume de fluide caloporteur déplacé par un moyen de circulation associé à une chambre d'extrémité peut correspondre à la moitié du volume de fluide caloporteur déplacé par un moyen de circulation associé à une chambre commune.

De préférence, les moyens de circulation peuvent être des pistons intégrés dans les chambres communes et les chambres d'extrémité et dont une seule extrémité agit sur le fluide caloporteur. Par extrémité, il faut comprendre la face ou tête de travail du piston qui est en contact avec le fluide caloporteur. Bien entendu, toute autre forme de moyen de circulation peut être prévue.

Dans une première forme de réalisation, ledit module thermique peut présenter une structure linéaire dans laquelle les éléments magnétocaloriques sont alignés et la manoeuvre desdits pistons peut être réalisée par une came de commande correspondante montée sur un arbre en rotation sur lui-même.

Dans cette configuration, ledit générateur thermique peut être constitué par quatre modules thermiques, ladite came de commande peut comporter des lobes décalés les uns des autres d'un angle de 90° et lesdits modules thermiques peuvent être disposés radialement autour dudit arbre de telle manière que chaque lobe actionne un piston de chacun desdits quatre modules thermiques.

Dans une seconde forme de réalisation, ledit module thermique peut présenter une structure linéaire dans laquelle les éléments magnétocaloriques sont alignés et la manoeuvre des pistons peut être réalisée par un charriot de manoeuvre se déplaçant selon un mouvement de translation de va-et-vient le long dudit module thermique et comportant une rainure de guidage dans laquelle sont guidés des éléments de liaison correspondants de chaque piston.

La rainure de guidage peut avoir une forme en dents de scie et les pistons peuvent être disposés sensiblement au droit du charriot de manoeuvre.

En outre, ledit générateur thermique peut comporter plusieurs modules thermiques disposés les uns au-dessus des autres selon une structure étagée.

L'invention prévoit encore que ledit générateur thermique peut comporter au moins deux modules thermiques et que, d'une part, les chambres d'extrémité chaude peuvent communiquer fluidiquement entre elles et que, d'autre part, les chambres d'extrémité froide peuvent communiquer fluidiquement entre elles.

En outre, le générateur thermique selon l'invention peut comporter au moins deux modules thermiques comprenant le même nombre d'éléments magnétocaloriques et les chambres communes desdits modules thermiques peuvent communiquer fluidiquement entre elles deux-à-deux.

### Description sommaire des dessins :

La présente invention et ses avantages apparaîtront mieux dans la description suivante d'un mode de réalisation donné à titre d'exemple non limitatif, en référence aux dessins annexés, dans lesquels:
- les figures 1A et 1B sont des vues schématiques d'un module thermique de l'art antérieur,
- les figures 2A et 2B sont des vues schématiques d'un module thermique constitué par quatre éléments magnétocaloriques respectivement dans deux états différents et illustrant le déplacement du fluide caloporteur à travers ces derniers,
- la figure 3 est une vue en perspective d'un premier mode de réalisation du générateur thermique selon l'invention,
- la figure 4 est une vue en élévation et en transparence du détail A de la figure 3, et
- la figure 5 est une vue en perspective d'un second mode de réalisation du générateur thermique selon l'invention.

### Illustrations de l'invention:

Dans les exemples de réalisation illustrés, les pièces ou parties identiques portent les mêmes références numériques.

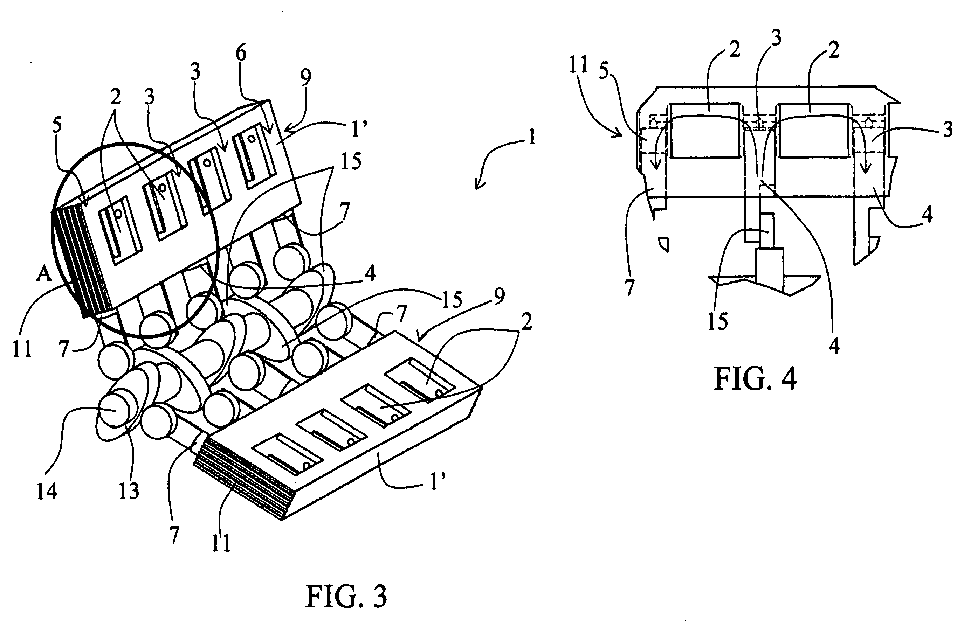

Le générateur thermique 1 représenté dans les figures 3 et 4 est réalisé selon un premier mode de réalisation de l'invention. Il comporte deux modules thermiques 1' comportant chacun des éléments magnétocaloriques 2 alignés. Une chambre commune 3 comportant un piston 4 formant un moyen de circulation forcée du fluide caloporteur est à chaque fois disposée entre deux éléments magnétocalorique 2 adjacents. En outre, ledit module thermique 1' comporte également deux chambres d'extrémité 5 et 6 disposées aux extrémités chaude 9 et froide 11 dudit module thermique 1', et comportant également chacune un piston 7 formant un moyen de circulation.

Chaque élément magnétocalorique 2 est apte à être traversé par un fluide caloporteur entraîné par les pistons 4, 7 et est soumis à une variation de champ magnétique par l'intermédiaire d'un arrangement magnétique (non représenté) générant des cycles d'échauffement et de refroidissement alternés. Le déplacement des pistons 4, 7 est synchronisé avec la variation du champ magnétique de telle manière que le fluide caloporteur se déplace en direction de l'extrémité chaude 9 à travers chaque élément magnétocalorique 2 subissant un cycle d'échauffement (flèches en pointillés) et en direction de l'extrémité froide 11 à travers chaque élément magnétocalorique 2 subissant un cycle de refroidissement flèches en trait continu). Ce déplacement est possible grâce à la disposition des pistons 4, 7 dans les chambres communes 3 et les chambres d'extrémité 5, 6, et à la distribution spécifique de fluide caloporteur qui en découle. En effet, les pistons 4 dans les chambres communes 3 distribuent chacun le fluide caloporteur dans deux éléments magnétocaloriques 2 adjacents. Dans les figures 3 et 4, les pistons 4, 7 sont perpendiculaires à l'alignement des éléments magnétocaloriques 2 de telle manière que seule une extrémité desdits pistons 4, 7 assure le déplacement du fluide caloporteur. Bien entendu, une autre configuration est envisageable, sous réserve qu'une seule extrémité d'un piston 4 dans une chambre commune 3 soit en contact avec le fluide caloporteur et en assure le déplacement dans deux éléments magnétocaloriques 2.

Le déplacement du fluide caloporteur décrit ci-dessus permet de créer un gradient de température entre les extrémités chaude 9 et froide 11 du module thermique et de maintenir ce gradient lorsqu'il y a extraction ou échange d'énergie thermique avec une application ou un circuit extérieur. Le générateur thermique selon l'invention est en effet destiné à échanger de l'énergie thermique avec un ou plusieurs circuits extérieurs d'utilisation (chauffage, climatisation, tempérage, etc.) en y étant relié par l'intermédiaire d'au moins une chambre d'extrémité 5, 6, éventuellement par l'intermédiaire d'un échangeur de chaleur.

En outre, et cela est applicable dans les deux modes de réalisation illustrés, l'entraînement du fluide caloporteur depuis les chambres communes 3 à travers deux éléments magnétocaloriques 2 adjacents, et simultanément dans une direction d'écoulement différente dans chacun de ces deux éléments magnétocaloriques 2, présente de nombreux avantages par rapport aux générateurs connus dans lesquels le fluide circule simultanément à travers tous les éléments magnétocaloriques MC dans une première direction, du premier élément magnétocalorique au dernier élément magnétocalorique, puis à travers les mêmes éléments magnétocaloriques MC, mais dans la direction inverse de la première (cf. figures 1A et 1B).

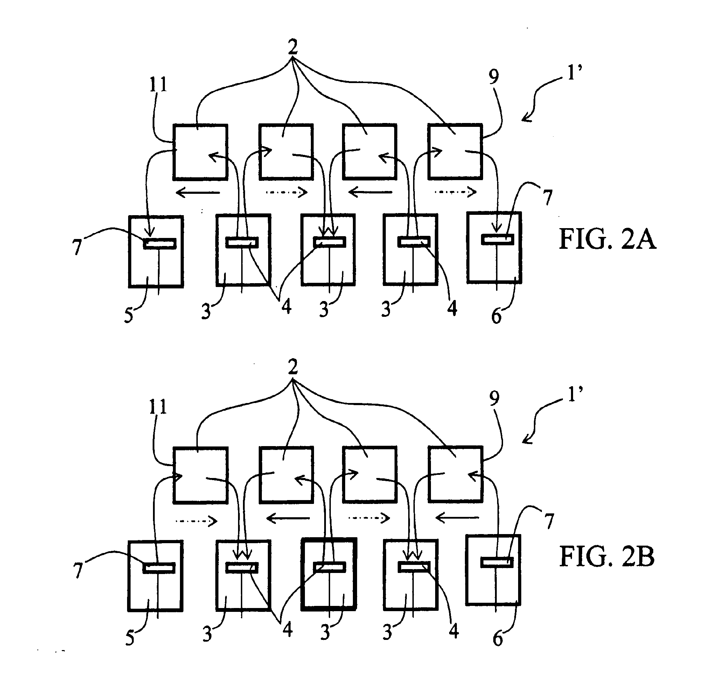

Un premier avantage ressort des figures 2A et 2B et réside dans le fait que les pertes de charge sont réparties et réduites, le fluide caloporteur entraîné par un piston 7 ne traversant qu'un élément magnétocalorique 2 à la fois et le fluide caloporteur entraîné par un piston 4 n'en traversant que deux à la fois, et non tous les éléments magnétocaloriques 2 constituant un module thermique 1', 10'. A cet effet, en référence aux figures 2A et 2B, les flèches dessinées sous les éléments magnétocaloriques 2 illustrent le sens de déplacement du fluide caloporteur, les flèches en pointillés correspondant à un déplacement vers l'extrémité chaude 9 et les flèches en trait plein illustrant un déplacement vers l'extrémité froide 11.

Un second avantage apparaît lorsque l'on compare le système connu représenté dans les figures 1A et 1B avec celui selon l'invention dans lesquels on est en présence d'une même longueur de matériau magnétocalorique. On constate que pour la même vitesse du fluide caloporteur traversant les éléments magnétocaloriques MC, 2, la fréquence des cycles est multipliée par quatre dans le générateur thermique 1, 10 de l'invention. Il en résulte que la puissance thermique d'un tel générateur thermique, 10 est également augmentée dans la même proportion.

A titre d'exemple illustratif, pour une vitesse de fluide caloporteur de 100 mm/s et une longueur de 100 millimètres par élément magnétocalorique :
- pour traverser tous les éléments magnétocaloriques MC du système connu représenté dans les figures 1A et 1B, le temps nécessaire est de (4 × 100) ÷ 100 = 4 secondes, ce qui équivaut à une fréquence de 0,25 hertz,
- alors que pour traverser tous les éléments magnétocaloriques 2 du générateur thermique 1, 10 selon l'invention, le temps nécessaire est de (1×100) ÷100 = 1 seconde, ce qui équivaut à une fréquence de 1 hertz.

Également, et toujours en comparant le générateur thermique 1, 10 selon l'invention avec le système connu, on constate que pour une même fréquence de cycles (démagnétisation et magnétisation), la vitesse de déplacement du fluide caloporteur est divisée par quatre dans le générateur thermique 1, 10 selon l'invention. Cela a pour effet que dans ce dernier, les pertes de charges sont réduites, ce qui équivaut à une augmentation du temps d'échange et donc de la puissance thermique de cet échange.

A titre d'exemple illustratif, pour une fréquence de 0,5 hertz correspondant à un cycle d'échauffement (ou magnétisation) d'une seconde et à un cycle de refroidissement (ou démagnétisation) d'une seconde et une longueur de 100 millimètres par élément magnétocalorique :
- pour traverser tous les éléments magnétocaloriques MC du système connu représenté dans les figures 1A et 1B pendant une seconde, il est nécessaire que la vitesse du fluide caloporteur soit de (4x0,100) ÷1 = 0,4 m/s,
- alors que pour traverser tous les éléments magnétocaloriques 2 du générateur thermique 1, 10 selon l'invention, la vitesse du fluide caloporteur entraîné au niveau de chaque chambre commune 3 est de (1×0,100) ÷ 1 = 0,1 m/s.

Les éléments magnétocaloriques 2 ne sont pas représentés dans la figure 3 ce, pour des raisons de simplification. Ces éléments magnétocaloriques comportent des passages de fluide débouchant qui peuvent être constitués par les pores d'un matériau poreux, des mini ou micro-canaux usinés dans un bloc plein ou obtenus par un assemblage de plaques rainurées superposées, par exemple.

De préférence, pour augmenter le gradient de température entre les extrémités chaude 9 et froide 11, lesdits éléments magnétocaloriques 2 sont disposés les uns par rapport aux autres selon leur température de Curie croissante, l'élément magnétocalorique 2 comportant la température de Curie la plus élevée étant disposé au niveau de l'extrémité chaude 9 du module thermique 1' concerné.

En outre, chaque élément magnétocalorique 2 peut être réalisé par un assemblage de plusieurs matériaux magnétocaloriques différents, également disposés selon leur température de Curie croissante.

Comme cela ressort de la figure 3, les pistons 4 intégrés dans les chambres communes 3 sont manoeuvrés par des cames de commande 13 montées sur un arbre 14 en rotation, lesdites cames comportant des lobes 15 décalés les uns par rapport aux autres d'un angle de 90°. Selon l'angle de rotation de l'arbre 14, les lobes 15 poussent ou non la tige des pistons 4, 7 correspondants, ce qui détermine le sens de déplacement de chaque piston 4, 7.

La figure 4 illustre les positions extrémales que peuvent prendre les pistons 4, 7. Les pistons 7 et 4 disposés respectivement dans la chambre extrémale 5 au niveau de l'extrémité froide 11 de l'élément 1' et dans une chambre commune 3 (à droite sur la figure 4) sont dans leur position de retrait, permettant au fluide caloporteur de remplir la chambre dans laquelle ils sont intégrés. Le piston central 4 est, quant à lui, dans une position de poussée du fluide contenu dans la chambre commune 3 correspondante en direction des deux éléments magnétocalorique 2 adjacents à ladite chambre commune 3 ce, dans deux sens opposés. Le fluide caloporteur se déplace selon les flèches courbes dessinées sur cette figure 4.

Il ressort clairement de cette figure que le volume de fluide caloporteur déplacé par le piston 7 associé à la chambre d'extrémité 5 correspond à la moitié du volume de fluide caloporteur déplacé par le piston 4 dans la chambre commune 3 adjacente.

En outre, notamment lorsqu'un nombre pair d'éléments magnétocaloriques 2 sont intégrés dans un module thermiques, les chambre communes 3 forment des bains intermédiaires permettant de moyenner la température du fluide caloporteur et ainsi de réduire le temps d'atteinte du gradient de température entre les extrémités chaude 9 et froide 11 de chaque module thermique 1, 10'.

Le générateur thermique 1 des figures 3 et 4 comporte deux modules thermiques 1'. Ce nombre n'est toutefois pas limitatif, il peut être inférieur ou supérieur, selon l'encombrement disponible et la puissance thermique nécessaire. En effet, ce générateur thermique 2 pourrait également comprendre quatre modules thermiques 1' disposés en étoile autour de l'arbre 14 et dont les pistons 4, 7 sont actionnés par les cames 13.

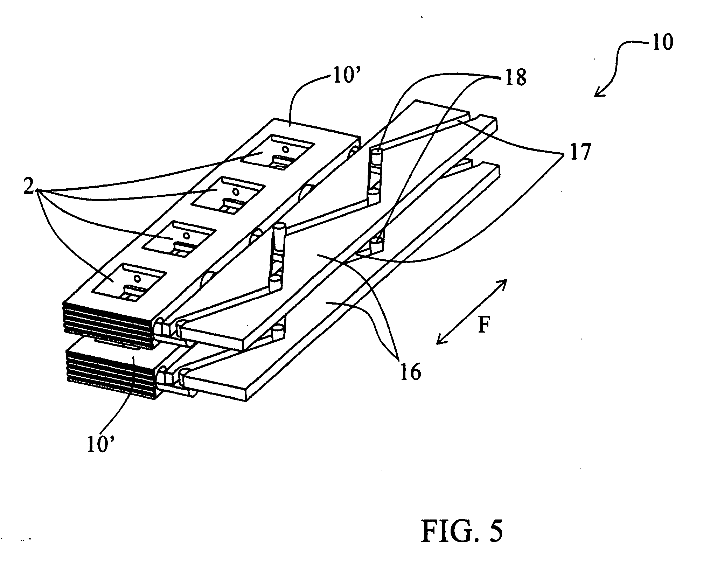

Le générateur thermique 10 représenté à la figure 5 se distingue du précédent par la manoeuvre des pistons 4, 7. Elle est réalisée par un chariot de manoeuvre 16 se déplaçant selon un mouvement de va-et-vient selon la flèche F le long du module thermique 10' concerné. Ce chariot de manoeuvre 16 comporte une rainure de guidage 17 en forme de dents de scie dans laquelle se déplacent des éléments de liaison 18 reliés aux pistons 4, 7.

Bien que le générateur thermique 10 représenté sur la figure 5 comporte deux modules thermiques 10' superposés, un générateur thermique 10 selon l'invention n'est pas limité à ce nombre de modules thermiques 10', ni à leur disposition de manière superposée.

En outre, bien que cela ne soit pas représenté dans les figures annexées, il peut être prévu, dans un générateur thermique selon l'invention comportant plusieurs modules thermiques, que d'une part, les chambres d'extrémité chaude 5 communiquent fluidiquement entre elles et que, d'autre part, les chambres d'extrémité froide 6 communiquent également fluidiquement entre elles. Il peut notamment être prévu que lesdites chambres d'extrémité chaude 5 soient confondues et ne forment qu'une seule et même chambre. Il en est de même pour les chambres d'extrémité froide 6.

Une telle configuration permet de relier thermiquement entre eux les différents modules thermiques et peut notamment faciliter l'échange thermique avec une application extérieure. Elle permet également d'additionner ou cumuler les puissances thermiques des différents modules thermiques.

Dans une variante supplémentaire, il est possible de prévoir que les chambres communes 3 des différents modules thermiques d'un générateur thermique selon l'invention communiquent fluidiquement entre elles deux-à-deux. Pour ce faire, les modules thermiques doivent comporter le même nombre d'éléments magnétocaloriques 2.

L'avantage d'une telle configuration réside dans le fait que les températures des chambres communes 3 sont lissées ou moyennées pour obtenir une régularité de fonctionnement du générateur thermique.

### Possibilités d'application industrielle:

Il ressort clairement de cette description que l'invention permet d'atteindre les buts fixés, à savoir proposer un générateur thermique 1, 10 de construction simple et d'efficacité améliorée.

Un tel générateur thermique 1, 10 peut trouver une application aussi bien industrielle que domestique dans le domaine du chauffage, de la climatisation, du tempérage, refroidissement ou autres, ce, à des coûts compétitifs et dans un faible encombrement.

En outre, toutes les pièces composant ce générateur thermique 1, 10 peuvent être réalisées selon des processus industriels reproductibles.

La présente invention n'est pas limitée aux exemples de réalisation décrits mais s'étend à toute modification et variante évidentes pour un homme du métier tout en restant dans l'étendue de la protection définie dans les revendications annexées.

## Revendications

1. Générateur thermique (1, 10), comportant au moins un module thermique (1', 10') comprenant au moins deux éléments magnétocaloriques (2) adjacents agencés pour être traversés par un fluide caloporteur, une chambre commune (3) de distribution associée à un moyen de circulation (4) du fluide caloporteur reliant fluidiquement entre eux lesdits éléments magnétocaloriques (2) adjacents et deux chambres d'extrémité (5, 6) également associées à un moyen de circulation (7) étant reliées fluidiquement respectivement avec l'élément magnétocalorique (2) situé aux extrémités dudit module thermique (1', 10'), dites extrémité chaude (9) et extrémité froide (11), et un arrangement magnétique destiné à soumettre chaque élément magnétocalorique (2) à un champ magnétique variable, créant alternativement, dans chaque élément magnétocalorique (2) un cycle de chauffage et un cycle de refroidissement, la circulation du fluide caloporteur à travers lesdits éléments magnétocaloriques (2) étant réalisée par les moyens de circulation (4, 7) en synchronisation avec la variation du champ magnétique, générateur thermique (1, 10) **caractérisé en ce que** ledit moyen de circulation (4) associé à ladite chambre commune (3) de distribution déplace le fluide caloporteur simultanément à travers les deux éléments magnétocaloriques (2) adjacents, dans des sens de circulation différents.

2. Générateur thermique, selon la revendication 1, **caractérisé en ce que** l'arrangement magnétique assujettit constamment lesdits éléments magnétocaloriques (2) adjacents dans deux cycles différents et **en ce que** ledit moyen de circulation (4) associé à ladite chambre commune (3) déplace le fluide caloporteur de manière simultanée, à travers l'élément magnétocalorique (2) subissant un cycle de chauffage, en direction de l'extrémité chaude (9) et, à travers l'élément magnétocalorique (2) subissant un cycle de refroidissement, en direction de l'extrémité froide (11) dudit module thermique (1', 10').

3. Générateur thermique, selon l'une quelconque des revendications précédentes, **caractérisé en ce que** ledit module thermique (1', 10') comporte au moins trois éléments magnétocaloriques (2), **en ce que** ledit moyen de circulation (4) associé à ladite chambre commune (3) déplace le fluide caloporteur alternativement en direction des deux éléments magnétocaloriques (2) adjacents puis dans la direction opposée, en sortie desdits modules thermiques (2) adjacents, et inversement, **en ce que** deux moyens de circulation (4) de deux chambres communes (3) consécutives déplacent constamment le fluide caloporteur dans deux directions opposées, et **en ce que** les moyens de circulation (7) associés auxdites chambres d'extrémité (5, 6) déplacent le fluide caloporteur dans la direction opposée à celle de la chambre commune (3) qui leur est adjacente.

4. Générateur thermique, selon la revendication 3, **caractérisé en ce qu'**il comporte un nombre pair d'éléments magnétocaloriques (2).

5. Générateur thermique, selon l'une quelconque des revendications précédentes, **caractérisée en ce que** lesdits éléments magnétocaloriques (2) comportent chacun une température de Curie différente et sont disposés de manière adjacente selon leur température de Curie croissante en direction de l'extrémité chaude (9) dudit module thermique.

6. Générateur thermique, selon l'une quelconque des revendications 3 et 4, **caractérisé en ce que** lesdits éléments magnétocaloriques (2) comportent chacun plusieurs matériaux magnétocaloriques agencés selon une température de Curie croissante en direction de l'extrémité chaude (9) dudit module thermique.

7. Générateur thermique, selon l'une quelconque des revendications précédentes, **caractérisé en ce que** le volume de fluide caloporteur déplacé par un moyen de circulation (7) associé à une chambre d'extrémité (5, 6) correspond à la moitié du volume de fluide caloporteur déplacé par un moyen de circulation (4) associé à une chambre commune (3).

8. Générateur thermique, selon l'une quelconque des revendications précédentes, **caractérisé en ce que** les moyens de circulation (4, 7) sont des pistons intégrés dans les chambres communes (3) et les chambres d'extrémité (5, 6) et dont une seule extrémité (12) agit sur le fluide caloporteur.

9. Générateur thermique, selon la revendication 8, **caractérisé en ce que** ledit module thermique (1') présente une structure linéaire dans laquelle les éléments magnétocaloriques (2) sont alignés et **en ce que** la manoeuvre desdits pistons (4, 7) est réalisée par une came de commande (13) correspondante montée sur un arbre (14) en rotation sur lui-même.

10. Générateur thermique, selon la revendication 9, **caractérisé en ce qu'**il est constitué par quatre modules thermiques (1'), **en ce que** ladite came de commande (13) comporte des lobes (15) décalés les uns des autres d'un angle de 90° et **en ce que** lesdits modules thermiques (1') sont disposés radialement autour dudit arbre (14) de telle manière que chaque lobe (15) actionne un piston (4, 7) de chacun desdits quatre modules thermiques (1').

11. Générateur thermique, selon l'une quelconque des revendications 1 à 7, **caractérisé en ce que** ledit module thermique (10') présente une structure linéaire dans laquelle les éléments magnétocaloriques (2) sont alignés et **en ce que** la manoeuvre des pistons (4, 7) est réalisée par un charriot de manoeuvre (16) se déplaçant selon un mouvement de translation de va-et-vient le long dudit module thermique (10') et comportant une rainure de guidage (17) dans laquelle sont guidés des éléments de liaison (18) correspondants de chaque piston (4,7).

12. Générateur thermique, selon la revendication 11, **caractérisé en ce que** la rainure de guidage (15) a une forme en dents de scie et **en ce que** les pistons (4, 7) sont disposés sensiblement au droit du chariot de manoeuvre (16).

13. Générateur thermique, selon l'une quelconque des revendications 11 ou 12, **caractérisé en ce qu'**il comporte plusieurs modules thermiques (10') disposés les uns au-dessus des autres selon une structure étagée.

14. Générateur thermique, selon l'une quelconque des revendications précédentes, **caractérisé en ce qu'**il comporte au moins deux modules thermiques (1', 10') et **en ce que**, d'une part, les chambres d'extrémité chaude (5) communiquent fluidiquement entre elles et que, d'autre part, les chambres d'extrémité froide (6) communiquent fluidiquement entre elles.

15. Générateur thermique, selon l'une quelconque des revendications précédentes, **caractérisé en ce qu'**il comprenant au moins deux modules thermiques (1', 10') comportant le même nombre d'éléments magnétocaloriques (2) et **en ce que** les chambres communes (3) desdits modules thermiques (1', 10') communiquent fluidiquement entre elles deux-à-deux.

## Claims

1. Heat generator (1, 10) comprising at least one thermal module (1', 10') containing at least two adjacent magnetocaloric elements (2) arranged for being passed through by a heat transfer fluid, a common distribution chamber (3) associated with a heat transfer fluid circulation means (4) connecting fluidically with each other said adjacent magnetocaloric elements (2) and two end chambers (5, 6) also associated to a circulation means (7) and connected fluidically respectively with the magnetocaloric element (2) located at the ends of said thermal module (1', 10'), called hot end (9) and cold end (11), and a magnetic arrangement intended to subject each magnetocaloric element (2) to a variable magnetic field, creating alternately in each magnetocaloric element (2) a heating cycle and a cooling cycle, the circulation of the heat transfer fluid through said magnetocaloric elements (2) being ensured by the circulation means (4, 7) in synchronization with the variation of the magnetic field, **characterized in that** said circulation means (4) associated to said common chamber (3) displaces the heat transfer fluid simultaneously through the two adjacent magnetocaloric elements (2), in different directions of circulation.

2. Heat generator according to claim 1, **characterized in that** the magnetic arrangement constantly subjects said adjacent magnetocaloric elements (2) in two different cycles and **in that** said circulation means (4) associated with said common chamber (3) moves the heat transfer fluid in a simultaneous way, through the magnetocaloric element (2) subjected to a heating cycle, towards the hot end (9) and, through the magnetocaloric element (2) subjected to a cooling cycle, towards the cold end (11) of said thermal module (1', 10').

3. Heat generator according to any of the previous claims, **characterized in that** said thermal module (1', 10') comprises at least three magnetocaloric elements (2), **in that** said circulation means (4) associated with said common chamber (3) moves the heat transfer fluid alternately towards the two adjacent magnetocaloric elements (2), and then in the opposite direction, at the outlet of said adjacent heat modules (2), and conversely, **in that** two circulation means (4) of two consecutive common chambers (3) move constantly the heat transfer fluid in two opposite directions, and **in that** the circulation means (7) associated to said end chambers (5, 6) move the heat transfer fluid in the direction opposite to that of the common chamber (3) adjacent to them.

4. Heat generator according to claim 3, **characterized in that** it comprises an even number of magnetocaloric elements (2).

5. Heat generator according to any of the previous claims, **characterized in that** all said magnetocaloric elements (2) have a different Curie temperature and are arranged adjacently according to their increasing Curie temperature towards the hot end (9) of said thermal module.

6. Heat generator according to any of claims 3 and 4, **characterized in that** said magnetocaloric elements (2) comprise each several magnetocaloric materials arranged according to an increasing Curie temperature towards the hot end (9) of said thermal module.

7. Heat generator according to any of the previous claims, **characterized in that** the volume of heat transfer fluid moved by a circulation means (7) associated with an end chamber (5, 6) corresponds to half of the volume of heat transfer fluid moved by a circulation means (4) associated with a common chamber (3).

8. Heat generator according to any of the previous claims, **characterized in that** the circulation means (4, 7) are pistons integrated in the common chambers (3) and the end chambers (5, 6) and of which only one end (12) acts upon the heat transfer fluid.

9. Heat generator according to claim 8, **characterized in that** said thermal module (1') has a linear structure in which the magnetocaloric elements (2) are aligned and **in that** said pistons (4, 7) are actuated by a corresponding driving cam (13) mounted on a shaft (14) rotating on itself.

10. Heat generator according to claim 9, **characterized in that** it is made of four thermal modules (1'), **in that** said driving cam (13) comprises lobes (15) offset from each other by an angle of 90° and **in that** said thermal modules (1') are arranged radially around said shaft (14) so that each lobe (15) actuates a piston (4, 7) of each of said four thermal modules (1').

11. Heat generator according to any of claims 1 to 7, **characterized in that** said thermal module (10') has a linear structure in which the magnetocaloric elements (2) are aligned and **in that** the pistons (4, 7) are actuated by a driving carriage (16) that moves according to a reciprocating movement along said thermal module (10') and comprising a guide groove (17) in which corresponding linking elements (18) of each piston (4, 7) are guided.

12. Heat generator according to claim 11, **characterized in that** the guide groove (15) has a serrated shape and **in that** the pistons (4, 7) are arranged approximately in front of the driving carriage (16).

13. Heat generator according to any of claims 11 or 12, **characterized in that** it comprises several thermal modules (10') arranged above each other according to a stepped structure.

14. Heat generator according to any of the previous claims, **characterized in that** it comprises at least two thermal modules (1', 10') and **in that**, on the one hand, the hot end chambers (5) communicate fluidically with each other and that, on the other side, the cold end chambers (6) communicate fluidically with each other.

15. Heat generator according to any of the previous claims, **characterized in that** it comprises at least two thermal modules (1', 10') comprising the same number of magnetocaloric elements (2) and **in that** the common chambers (3) of said thermal modules (1', 10') communicate fluidically with each other two by two.

## Patentansprüche

1. Thermischer Generator (1, 10) mit zumindest einem Wärme-Modul (1', 10'), welches zumindest zwei anliegende magnetokalorische Elemente (2) beträgt, die angeordnet sind, um von einem Wärmeübertragungsfluid durchströmt zu werden, eine mit einem Mittel (4) zum Umlauf des Wärmeübertragungsfluids zusammenarbeitende gemeinsame Verteilerkammer (3), die die besagten anliegenden magnetokalorischen Elemente (2) untereinander in Fluidverbindung setzt, und zwei Endkammern (5, 6), die ebenfalls mit einem Mittel (7) zum Umlauf zusammenarbeiten, die mit dem an dem sogenannten warmen (9) bzw. kalten (11) Ende des besagten Wärme-Moduls (1', 10') angeordneten magnetokalorischen Element (2) in Fluidverbindung stehen, und eine magnetische Anordnung, die ausgelegt ist, um jedes magnetokalorische Element (2) einem variablen Magnetfeld auszusetzen, das in jedem magnetokalorischen Element (2) abwechselnd einen Heiz-Zyklus und einen Kühl-Zyklus erzeugt, wobei das Wärmeübertragungsfluid von den Mitteln zum Umlauf (4, 7) synchron mit der Magnetfeld-Variation durch die besagten magnetokalorischen Elemente (2) hindurch bewegt wird, **dadurch gekennzeichnete**r thermischer Generator (1, 10), dass das besagte, mit der besagten gemeinsamen Verteilerkammer (3) zusammenarbeitende Mittel (4) zum Umlauf das Wärmeübertragungsfluid gleichzeitig in unterschiedliche Bewegungsrichtungen durch die beiden anliegenden magnetokalorischen Elemente (2) bewegt.

2. Thermischer Generator nach Anspruch 1, **dadurch gekennzeichnet, dass** die magnetische Anordnung die besagten anliegenden magnetokalorischen Elemente (2) ständig in zwei unterschiedlichen Zyklen ansteuert, und dadurch, dass das besagte mit der besagten gemeinsamen Kammer (3) zusammenarbeitende Mittel (4) zum Umlauf das Wärmeübertragungsfluid gleichzeitig durch das einen Erwärmungs-Zyklus erfahrende magnetokalorische Element (2) in Richtung des warmen Endes (9) und durch das einen Abkühlungs-Zyklus erfahrende magnetokalorische Element (2) in Richtung des kalten Endes (11) des besagten thermischen Moduls (1', 10') hindurch bewegt.

3. Thermischer Generator nach einem beliebigen der vorhergehenden Ansprüche, **dadurch gekennzeichnet, dass** das besagte Wärme-Modul (1', 10') zumindest drei magnetokalorische Elemente (2) beträgt, dadurch, dass das besagte mit der besagten gemeinsamen Kammer (3) zusammenarbeitende Mittel (4) zum Umlauf das Wärmeübertragungsfluid abwechselnd in Richtung der beiden anliegenden magnetokalorischen Elemente (2) und anschließend in die entgegen gesetzte Richtung, aus den besagten anliegenden magnetothermischen Modulen (2) heraus, bewegt und umgekehrt, dadurch, dass die beiden Mittel (4) zum Umlauf von zwei aufeinanderfolgenden gemeinsamen Kammern (3) das Wärmeübertragungsfluid ständig in zwei entgegen gesetzte Richtungen bewegen, und dadurch, dass die mit den besagten End-Kammern (5, 6) zusammenarbeitenden Mittel (7) zum Umlauf das Wärmeübertragungsfluid in die der Richtung der ihnen anliegenden gemeinsamen Kammer (3) entgegen gesetzte Richtung bewegen.

4. Thermischer Generator nach Anspruch 3, **dadurch gekennzeichnet**, das er eine gerade Anzahl magnetokalorischer Elemente (2) aufweist.

5. Thermischer Generator nach einem beliebigen der vorhergehenden Ansprüche, **dadurch gekennzeichnet, dass** die besagten magnetokalorischen Elemente (2) jeweils eine unterschiedliche Curie-Temperatur aufweisen und nach ihrer steigenden Curie-Temperatur aneinander liegend in Richtung des warmen Endes (9) des besagten Wärme-Moduls angeordnet sind.

6. Thermischer Generator nach einem beliebigen der Ansprüche 3 und 4, **dadurch gekennzeichnet, dass** die besagten magnetokalorischen Elemente (2) jeweils mehrere magnetokalorische Materialien aufweisen, die nach ihrer steigenden Curie-Temperatur in Richtung des warmen Endes (9) des besagten Wärme-Moduls angeordnet sind.

7. Thermischer Generator nach einem beliebigen der vorhergehenden Ansprüche, **dadurch gekennzeichnet, dass** das von einem mit einer Endkammer (5, 6) zusammenarbeitenden Mittel (7) zum Umlauf in Bewegung gesetzte Wärmeübertragungsfluid-Volumen der Hälfte des von einem mit einer gemeinsamen Kammer (3) zusammenarbeitenden Mittel (4) zum Umlauf in Bewegung gesetzten Wärmeübertragungsfluid-Volumens entspricht.

8. Thermischer Generator nach einem beliebigen der vorhergehenden Ansprüche, **dadurch gekennzeichnet, dass** die Mittel (4, 7) zum Umlauf in den gemeinsamen Kammern (3) und in den Endkammern (5, 6) integrierte Kolben sind, von denen nur ein Ende (12) das Wärmeübertragungsfluid in Bewegung setzt.

9. Thermischer Generator nach Anspruch 8, **dadurch gekennzeichnet, dass** das besagte Wärme-Modul (1') eine lineare Struktur aufweist, in der die magnetokalorischen Elemente (2) auf einer Reihe angeordnet sind, und dadurch, dass die Betätigung der besagten Kolben (4, 7) durch einen entsprechenden Steuernocken (13) erfolgt, der auf eine auf sich selbst drehende Welle (14) montiert ist.

10. Thermischer Generator nach Anspruch 9, **dadurch gekennzeichnet, dass** er aus vier Wärme-Modulen (1') besteht, dadurch, dass der besagte Steuernocken (13) untereinander um 90° versetzte Nockenvorsprünge (15) beträgt, und dadurch, dass die besagten Wärme-Module (1') radial um die besagte Welle (14) herum angeordnet sind, so dass jeder Nockenvorsprung (15) einen Kolben (4, 7) von jedem der besagten vier Wärme-Module (1') betätigt.

11. Thermischer Generator nach einem beliebigen der Ansprüche 1 bis 7, **dadurch gekennzeichnet, dass** das besagte Wärme-Modul (10') eine lineare Struktur aufweist, in der die magnetokalorischen Elemente (2) auf einer Reihe angeordnet sind, und dadurch, dass die Betätigung der Kolben (4, 7) durch einen Betätigungs-Schlitten (16) erfolgt, der sich in einer Hin-und-Her-Translationsbewegung entlang des besagten Wärme-Moduls (10') bewegt und eine Führungsnut (17) aufweist, in der entsprechende Verbindungselemente (18) jedes Kolbens (4,7) geführt sind.

12. Thermischer Generator nach Anspruch 11, **dadurch gekennzeichnet, dass** die Führungsnut (15) sägezahnförmig ist, und dadurch, dass die Kolben (4, 7) merklich senkrecht über dem Betätigungs-Schlitten (16) angeordnet sind.

13. Thermischer Generator nach einem beliebigen der Ansprüche 11 oder 12, **dadurch gekennzeichnet, dass** er mehrere Wärme-Module (10') beträgt, die in einer abgestuften Struktur übereinander angeordnet sind.

14. Thermischer Generator nach einem beliebigen der vorhergehenden Ansprüche, **dadurch gekennzeichnet, dass** er zumindest zwei Wärme-Module (1', 10') beträgt und dadurch, dass einerseits die warmen Endkammern (5) untereinander in Fluidverbindung stehen und dass, andererseits die kalten Endkammern (6) untereinander in Fluidverbindung stehen.

15. Thermischer Generator nach einem beliebigen der vorhergehenden Ansprüche, **dadurch gekennzeichnet, dass** er zumindest zwei Wärme-Module (1', 10') mit derselben Anzahl magnetokalorischer Elemente (2) beträgt und dadurch, dass die gemeinsamen Kammern (3) der besagten Wärme-Module (1', 10') paarweise untereinander in Fluidverbindung stehen.
